# EUROPEAN PATENT SPECIFICATION

(11) **EP 1 446 992 B1**
(45) Date of publication and mention of the grant of the patent: **24.10.2007**
(21) Application number: 02772572.0
(22) Date of filing: 25.10.2002
(51) Int. Cl.: H05K 3/34

(54) **METHOD OF FORMING A MASK ON A SURFACE**
VERFAHREN ZUM ANBRINGEN EINER MASKE AUF EINE FLÄCHE
PROCEDE DE FORMATION D'UN MASQUE SUR UNE SURFACE

(30) Priority: 02.11.2001 GB 0126404
(43) Date of publication of application: 18.08.2004
(73) Proprietor: Patterning Technologies Limited, Hemel Hempstead, Herts HP2 7RH (GB)
(72) Inventor: STOUTE, S. J., c/o Patterning Technologies Ltd., Hemel Hempstead, Herts HP2 7RH (GB); SEAL, Michael D., c/o Patterning Technologies Ltd, Hemel Hempstead, Herts HP2 7RH (GB); GARDNER, Ina A., c/o Patterning Technologies Ltd., Hemel Hempstead, Herts HP2 7RH (GB); FERGUSON, W. J., c/o Patterning Technologies Ltd., Hemel Hempstead, Herts HP2 7RH (GB); BRESLER, Eric, c/o Patterning Technologies Limited, Hemel Hempstead, Herts HP2 7RH (GB)
(74) Representative: Milhench, Mark Lorne
(86) International application number: PCT/GB2002/004892
(87) International publication number: WO 2003/039218

(56) References cited:
- EP-A- 0 899 787

## Description

The present invention relates to a method of forming a mask on a surface. In one particular embodiment, the present invention relates to method of forming a solder mask, or resist, on a surface, such as a circuit board.

Known methods for forming a solder mask on a surface include screen printing and photolithography.

Screen printing typically uses a patterned fabric screen having perforations corresponding to those areas of the circuit board that require resist protection. The screen is positioned over the circuit board and a large amount of material is placed on the screen. A drawing rod is then pulled across the screen, and when the screen is lifted away from the board a resist pattern is left on the board. This pattern typically has a uniform thickness and reasonably accurate definition. The thus deposited solder mask is then cured. Advantages of this method are the speed at which a board can be covered and the high repeatability of the process. The disadvantages associated with screen printing are the quantity of material wasted, the relatively long lead times, the cost of fabricating a screen and also the need to dispose of waste material. This method is also rather restricted at resolving feature sizes below 150 microns.

Photolithography involves fully covering a circuit board with a photoresist (using, for example, dry film lamination, screen printing, curtain coating or spray coating) and subsequently exposing the photoresist to UV light through a phototool, such as a contact mask, a proximity mask, or a projection mask, for selectively masking areas of the photoresist. After developing the exposed areas of the photoresist, the masked areas can be removed by etching to leave the desired features for further processing. The advantages of this technique are the accuracy of the final image and the speed at which boards can be coated and patterned. The disadvantages however, are the need to chemically dispose of waste material and the multi-stage subtractive process.

In a first aspect the present invention provides a method of forming a solder mask on a surface, the method utilising the technique of drop on demand ejection to deposit selectively material on said surface, said method comprising the steps of:
(a) depositing material on said surface to form an outline of the mask on the surface; and
(b) subsequently depositing material within said outline to form said mask.
wherein the formed outline has a greater height than the remainder of the mask subsequently formed during step (b) so as to provide a barrier for controlling the flow of material deposited during step (b).

Preferably, step (a) further comprises exposing the deposited material to electromagnetic radiation to effect curing of the deposited material.

The method preferably comprises, prior to step (b), repeating step (a) at least once so as to build up said outline from a plurality of depositions of material. The method preferably comprising repeating step (b) at least once, step (b) being repeated a number of times which is less than or equal to the number of times that step (a) is repeated.

Preferably, at least once step (b) comprises exposing the material deposited during that step to electromagnetic radiation to effect curing of that material. The time delay between completing deposition and exposing the deposited material to electromagnetic radiation may be selectively varied so as to control the surface finish of the deposited mask.

The remainder of the mask may be deposited so as to form regions of locally greater height, for example, to protect certain features of the circuit board during subsequent processing or to provide a thicker dielectric. This may be achieved by means of additional selective depositions of material during formation of the remainder of the mask or by locally depositing droplets of greater size using known "greyscale" technology.

At least part of the outline may defines those areas of the surface on which material is not to be deposited, material being deposited during step (b) outside of those areas. Thus, in a second aspect, the present invention provides a method of forming a solder mask on a surface, the method utilising the technique of drop on demand ejection to deposit selectively material on said surface, said method comprising the steps of depositing material on said surface to form an outline of those areas of the surface on which material is not to be deposited, and subsequently depositing material outside of the outline to form said mask, wherein the formed outline has a greater height than the remainder of the mask subsequently formed on said surface so as to provide a barrier for controlling the flow of material deposited outside of the outline. Features described above in relation to the first aspect may equally be applied to the second aspect.

The electromagnetic radiation may comprise one of ultra violet and infra red radiation. The deposition material may comprise one of acrylic, silicone, polyimide, polytetrafluoroethylene, and epoxy.

It has been found by the inventors of the present invention that a suitable mask material may be deposited on a surface using a commercially available drop on demand inkjet printhead and preferably subsequently cured using electromagnetic radiation to leave a solder mask covering the desired areas of the surface. The inventors have found that the present invention enables a mask to be formed quickly, accurately and at low cost with excellent control over the printed surface coating. This method offers further advantages over conventional technology in the effective use of ink, the reduction in waste from the process, removal of tooling costs and the versatility and flexibility of direct imaging.

The inventors have found that a plurality of steps are required to form the mask accurately, in contrast to producing an image and ink jetting the whole pattern in one step. To illustrate this point consider a conventional desktop printer where the user can produce a data file and output via a printer to paper in a single step. Most businesses use laser printers instead of drop on demand or continuous jet printers because image quality is significantly better using laser printers. This difference in quality is because of the wetting nature of fluid and the capillary action paper exerts when wet. As a printer product this results in a blurred and dull image.

When printing a solder mask using a single deposition step, the same effect is seen, in that the image detail one wishes to preserve is blurred and inaccurate. One way of sustaining the image quality is by curing the deposited image without delay, which in turn prevents the fluid from spreading and distorting the image features. However, when the image is laid down directly the finish to the coating is unattractive and non-uniform across the surface. So, in short there is a compromise between having a smooth finish and poor definition, and good image definition and poor surface finish.

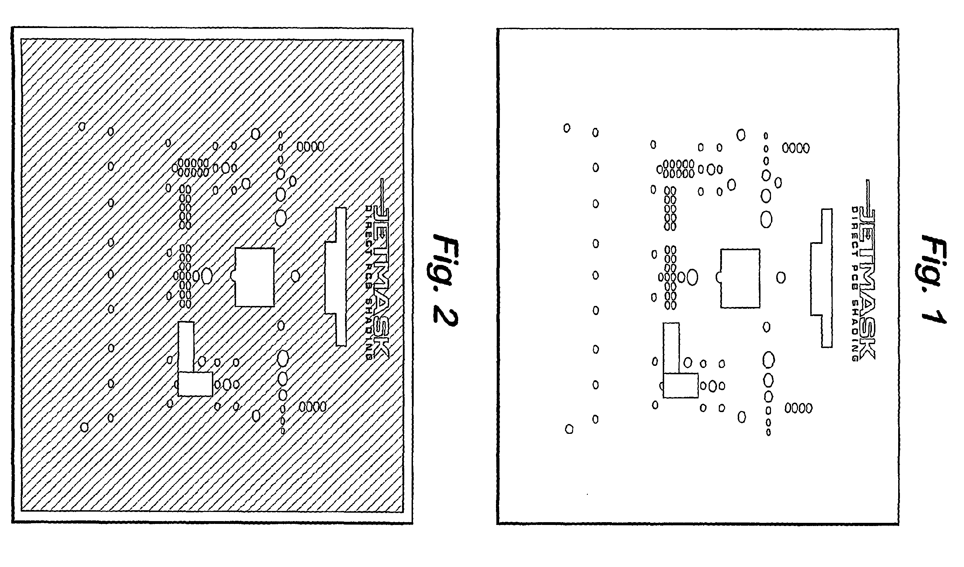

The present invention provides two different deposition steps to enable a good image quality and a smooth finish to be achieved on the deposition surface. The method involves firstly printing the outline of any design features the user may want to include, and preferably overprinting the outline several times, such that the height of ink is built up. The purpose of this is to create a dam, which provides a barrier to contain and control the flow of ink from flowing into areas where interconnections are made and need to be free of solder mask. Next, the dam contained can be filled and the soldermask allowed to flow naturally, thus giving a smooth finish before any final curing. Figure 1 illustrates an example of an image of outlines put down on the circuit board first. As described above this is to control the natural flow of the fluid used when infilling the image. Figure 2 illustrates the image deposited on the areas that need solder mask coverage. CAD/CAM software packages are able to provide the two sets of images required with minor scripting.

### Example

To produce a solder mask on a surface specific parameters were used to set the print head parameters and curing rates. A single XaarJet^{™} XJ500 printhead was set to a temperature of 40°C and a supply voltage of 35.5V. A curing lamp was positioned approximately 12mm above the substrate during an initial cure. The ink to be deposited comprised acrylate oligomers and isobornyl acrylate monomer (to reduce viscosity), UV curing agents and pigment. To initially cure this ink formulation a minimum of 15mJ is required from a UV (Xenon) light source.

During the deposition of the outline pattern a deposition and curing speed of 280 mm/s was used, this equates to curing between 0.05 and 2 seconds, preferably approximately 0.5s, after ink deposition. Three 720dpi outline layers were printed sequentially in this manner, leaving a clear outline of the pattern. To allow for interlacing, each layer was formed from four discrete print passes, or depositions of material, using the single printhead. By using four printheads, a 720dpi layer may be formed in a single pass.

During the second deposition stage (infill), two 720dpi layers were deposited to form the solder mask. Each pass making up the first layer was cured without any delay between 0.05 and 2 seconds, preferably approximately 0.5s, after deposition. For the second layer, no curing was performed for the first and third passes respectively, curing being performed for the second and fourth passes approximately 10s after deposition.

In summary, a method of forming a mask, preferably a solder mask, on a surface utilises the technique of drop on demand ejection to deposit selectively material on said surface. The method comprises the steps of depositing material on said surface to form an outline of the mask on the surface; and subsequently depositing material within said outline to form said mask. Alternatively, the method comprises the steps of depositing material on said surface to form an outline of those parts of the surface on which material is not to be deposited, and subsequently depositing material outside of said outline to form said mask. The height of the outline is greater than that of the remainder of the mask so as to provide a barrier for restricting the flow of material subsequently deposited on the surface.

It will be understood that the present invention has been described above purely by way of example, and modifications of detail can be made within the scope of the invention.

## Claims

1. A method of forming a mask on a surface, the method utilising the technique of drop on demand ejection to deposit selectively material on said surface,
**characterised in that**:-
said method comprises the steps of:
(a) depositing material on said surface to form an outline of the mask on the surface; and
(b) subsequently depositing material within said outline to form said mask, said outline providing a barrier for controlling the flow of said subsequently deposited material on said surface.

2. A method according to Claim 1, wherein step (b) comprises filling the outline formed during step (a).

3. A method according to Claim 2, wherein the formed outline has a greater height than the remainder of the mask subsequently formed during step (b).

4. A method according to Claim 3, wherein step (a) further comprises exposing the deposited material to electromagnetic radiation to effect curing of the deposited material.

5. A method according to Claim 3 or 4, comprising, prior to step (b), repeating step (a) at least once so as to build up said outline from a plurality of depositions of material.

6. A method according to Claim 5, comprising repeating step (b) at least once, step (b) being repeated a number of times which is less than or equal to the number of times that step (a) is repeated.

7. A method according to Claim 6, wherein at least once step (b) comprises exposing the material deposited during that step to electromagnetic radiation to effect curing of that material.

8. A method according to Claim 7, wherein the time delay between completing deposition and exposing the deposited material to electromagnetic radiation is selectively varied so as to control the surface finish of the deposited mask.

9. A method according to any of Claims 3 to 8, wherein the remainder of the mask is deposited so as to form regions of locally greater height.

10. A method according to any of Claims 3 to 8, wherein at least part of said outline defines those areas of the surface on which material is not to be deposited, material being deposited during step (b) outside of those areas.

11. A method of forming a mask on a surface, the method utilising the technique of drop on demand ejection to deposit selectively material on said surface,
**characterised in that**:-
said method comprises the steps of:
depositing material on said surface to form an outline of those areas of the surface on which material is not to be deposited; and
subsequently depositing material outside of the outline to form said mask, said outline providing a barrier for controlling the flow of said subsequently deposited material on said surface.

12. A method according to Claim 11, wherein the formed outline has a greater height than the remainder of the mask subsequently formed during step (b).

13. A method according to any of Claims 4, 7 and 8, wherein said electromagnetic radiation comprises one of ultra violet and infra red radiation.

14. A method according to any of Claims 3 to 13, wherein said deposition material comprises one of acrylic, silicone, polyimide, polytetrafluoroethylene, and epoxy.

15. A method according to any preceding claim, wherein said mask comprises a 3-dimensional structure.

16. A method according to any preceding claim, being a method for forming a solder mask.

17. A method according to any of Claims I to 15, wherein the mask is a resist.

18. A mask formed on a surface, said mask being formed utilising the technique of drop on demand ejection to deposit selectively material on said surface,
**characterised in that**:-
said mask comprises:-
an outline formed by deposition of material on said surface; and
material subsequently deposited on said surface,
said outline providing a barrier which controlled flow on said surface, during formation of said mask, of said subsequently deposited material.

19. A mask according to Claim 18, wherein said subsequently deposited material has been allowed to flow freely to form said mask.

20. A mask according to Claim 18 or 19, wherein said outline has a greater height than said subsequently deposited material.

21. A mask according to any of Claims 18 to 20, being a three dimensional structure.

22. A mask according to any of Claims 18 to 21, being a solder mask.

23. A mask according to any of Claims 18 to 21, being a resist.

## Patentansprüche

1. Verfahren zum Erzeugen einer Maske auf einer Fläche, wobei Tropfen in Tintenstrahltechnik ausgestoßen werden, um Material selektiv auf die Fläche aufzutragen, **dadurch gekennzeichnet, dass**
(a) Material auf die Fläche aufgetragen wird, um darauf eine Kontur der Maske zu erzeugen, und
(b) anschließend innerhalb der Kontur Material aufgetragen wird, um die Maske zu erzeugen, wobei die Kontur eine Barriere für die Steuerung des Flusses des anschließend auf die Fläche aufgetragenen Materials bildet.

2. Verfahren nach Anspruch 1, wobei im Schritt (b) die im Schritt (a) erzeugte Kontur ausgefüllt wird.

3. Verfahren nach Anspruch 2, wobei die erzeugte Kontur höher ist als der anschließend im Schritt (b) erzeugte Rest der Maske.

4. Verfahren nach Anspruch 3, wobei im Schritt (a) das aufgetragene Material elektromagnetischer Strahlung zur Härtung ausgesetzt wird.

5. Verfahren nach Anspruch 3 oder 4, wobei der Schritt (a) vor dem Schritt (b) mindestens einmal wiederholt wird, um die Kontur aus mehreren Materialaufträgen auszubilden.

6. Verfahren nach Anspruch 5, wobei der Schritt (b) mindestens einmal wiederholt wird und die Zahl der Wiederholungen des Schrittes (b) kleiner oder gleich der Zahl der Wiederholungen des Schrittes (a) ist.

7. Verfahren nach Anspruch 6, wobei in mindestens einem Schritt (b) das dabei aufgetragene Material elektromagnetischer Strahlung zur Härtung ausgesetzt wird.

8. Verfahren nach Anspruch 7, wobei die Verzögerung zwischen dem vollständigen Auftrag und der Anwendung von elektromagnetischer Strahlung auf das aufgetragene Material selektiv variiert wird, um den Oberfächenzustand der aufgetragenen Maske zu steuern.

9. Verfahren nach einem der Ansprüche 3 bis 8, wobei der Rest der Maske so aufgetragen wird, dass örtlich höhere Bereiche entstehen.

10. Verfahren nach einem der Ansprüche 3 bis 8, wobei mindestens ein Teil der Kontur diejenigen Bereiche der Fläche definiert, auf die kein Material aufgetragen wird, und wobei im Schritt (b) Material außerhalb dieser Bereiche aufgetragen wird.

11. Verfahren zum Erzeugen einer Maske auf einer Fläche, wobei Tropfen in Tintenstrahltechnik ausgestoßen werden, um selektiv Material auf die Fläche aufzutragen, **dadurch gekennzeichnet, dass**
(a) auf die Fläche Material aufgetragen wird, um eine Kontur derjenigen Bereiche der Fläche zu erzeugen, auf die kein Material aufgetragen wird, und
(b) anschließend außerhalb der Kontur Material aufgetragen wird, um die Maske zu erzeugen, wobei die Kontur eine Barriere zur Steuerung des Flusses des anschließend auf die Fläche aufgetragenen Materials bildet.

12. Verfahren nach Anspruch 11, wobei die erzeugte Kontur höher ist als der anschließend im Schritt (b) erzeugte Rest der Maske.

13. Verfahren nach einem der Ansprüche 4, 7 und 8, wobei die elektromagnetische Strahlung Ultraviolett- oder Infrarotstrahlung ist.

14. Verfahren nach einem der Ansprüche 3 bis 13, wobei das Auftragsmaterial Acryl, Silikon, Polyimid, Polytetrafluorethylen oder Epoxiharz ist.

15. Verfahren nach einem der vorhergehenden Ansprüche, wobei die Maske eine dreidimensionale Struktur hat.

16. Verfahren nach einem der vorhergehenden Ansprüche zur Erzeugung einer Lötmaske.

17. Verfahren nach einem der Ansprüche 1 bis 15, wobei die Maske aus einem Resist-Material besteht.

18. Auf einer Fläche ausgebildete Maske, die **dadurch** erzeugt ist, dass Tropfen in Tintenstrahltechnik ausgestoßen werden, um selektiv Material auf die Fläche aufzutragen,
**dadurch gekennzeichnet, dass** die Maske aufweist:
eine durch Materialauftrag auf der Fläche erzeugte Kontur und
anschließend auf die Fläche aufgetragenes Material,
wobei die Kontur eine Barriere bildet, die während der Erzeugung der Maske den Fluss des anschließend auf die Fläche aufgetragenen Materials steuert.

19. Maske nach Anspruch 18, wobei das anschließend aufgetragene Material zur Erzeugung der Maske frei geflossen ist.

20. Maske nach Anspruch 18 oder 19, wobei die Kontur höher ist als das anschließend aufgetragene Material.

21. Maske nach einem der Ansprüche 18 bis 20 mit dreidimensionaler Struktur.

22. Maske nach einem der Ansprüche 18 bis 21, bei der es sich um eine Lötmaske handelt.

23. Maske nach einem der Ansprüche 18 bis 21 aus Resist-Material.

## Revendications

1. Procédé de formation d'un masque sur une surface, le procédé utilisant la technique d'éjection de gouttes sur demande afin de déposer sélectivement un matériau sur ladite surface, **caractérisé en ce que** ledit procédé comprend les étapes consistant à :
(a) déposer un matériau sur ladite surface afin de former un contour du masque sur la surface, et
(b) déposer ensuite un matériau à l'intérieur dudit contour afin de former ledit masque, ledit contour fournissant une barrière pour réguler l'écoulement dudit matériau déposé ultérieurement sur ladite surface.

2. Procédé selon la revendication 1, dans lequel l'étape (b) comprend de remplir le contour formé pendant l'étape (a).

3. Procédé selon la revendication 2, dans lequel le contour formé a une hauteur supérieure au reste du masque formé ultérieurement pendant l'étape (b).

4. Procédé selon la revendication 3, dans lequel l'étape (a) comprend en outre d'exposer le matériau déposé à une radiation électromagnétique pour effectuer un durcissement du matériau déposé.

5. Procédé selon la revendication 3 ou 4, comprenant, avant l'étape (b), de répéter l'étape (a) au moins une fois de manière à façonner ledit contour à partir d'une pluralité de dépôts de matériau.

6. Procédé selon la revendication 5, comprenant de répéter l'étape (b) au moins une fois, l'étape (b) étant répétée un nombre de fois qui est inférieur ou égal au nombre de fois que l'étape (a) a été répétée.

7. Procédé selon la revendication 6, dans lequel au moins une fois l'étape (b) comprend d'exposer le matériau déposé pendant cette étape à une radiation électromagnétique pour effectuer un durcissement de ce matériau déposé.

8. Procédé selon la revendication 7, dans lequel l'intervalle de temps entre la fin du dépôt et l'exposition du matériau déposé à une radiation électromagnétique est varié sélectivement de manière à commander la finition de surface du masque déposé.

9. Procédé selon l'une quelconque des revendications 3 à 8, dans lequel le reste du masque est déposé de manière à former des régions de hauteur localement plus élevée.

10. Procédé selon l'une quelconque des revendications 3 à 8, dans lequel au moins une partie dudit contour définit ces régions de la surface sur lesquelles un matériau de doit pas être déposé, le matériau étant déposé pendant l'étape (b) en dehors de ces zones.

11. Procédé de formation d'un masque sur une surface, le procédé utilisant la technique d'éjection de gouttes sur demande afin de déposer sélectivement un matériau sur ladite surface, **caractérisé en ce que** ledit procédé comprend les étapes consistant à :
déposer un matériau sur ladite surface afin de former un contour de ces zones de la surface sur lesquelles le matériau ne doit pas être déposé, et
déposer ensuite un matériau en dehors du contour afin de former ledit masque, ledit contour fournissant une barrière pour réguler l'écoulement dudit matériau déposé ultérieurement sur ladite surface.

12. Procédé selon la revendication 11, dans lequel le contour formé a une hauteur supérieure au reste du masque formé ultérieurement pendant l'étape (b).

13. Procédé selon l'une quelconque des revendications 4, 7 et 8, dans lequel ladite radiation électromagnétique comprend l'une d'une radiation ultraviolette et infrarouge.

14. Procédé selon l'une quelconque des revendications 3 à 13, dans lequel ledit matériau de dépôt comprend l'un d'un acrylique, silicone, polyimide, polytétrafluoroéthylène et époxy.

15. Procédé selon l'une quelconque des revendications précédentes, dans lequel ledit masque comprend une structure en trois dimensions.

16. Procédé selon l'une quelconque des revendications précédentes étant un procédé de formation d'un masque de soudure.

17. Procédé selon l'une quelconque des revendications 1 à 15, dans lequel le masque est un élément de protection.

18. Masque formé sur une surface, ledit masque étant formé en utilisant la technique d'éjection de gouttes sur demande afin de déposer sélectivement un matériau sur ladite surface, **caractérisé en ce que** ledit masque comprend :
un contour formé par dépôt du matériau sur ladite surface, et
un matériau déposé ultérieurement sur ladite surface,
ledit contour fournissant une barrière qui a régulé l'écoulement sur ladite surface, pendant la formation dudit masque, dudit matériau déposé ultérieurement.

19. Masque selon la revendication 18, dans lequel ledit matériau déposé ultérieurement a été laissé s'écouler librement afin de former ledit masque.

20. Masque selon la revendication 18 ou 19, dans lequel ledit contour a une hauteur supérieure audit matériau déposé ultérieurement.

21. Masque selon l'une quelconque des revendications 18 à 20 étant une structure en trois dimensions.

22. Masque selon l'une quelconque des revendications 18 à 21 étant un masque de soudure.

23. Masque selon l'une quelconque des revendications 18 à 21 étant un élément de protection.
